Europäisches Patentamt

European Patent Office

Office européen des brevets

(11) Publication number: **0 587 265 A1**

## EUROPEAN PATENT APPLICATION

(21) Application number: 93302343.4

(22) Date of filing: 26.03.93

(51) Int. Cl.5: **H03F 3/45**, H03F 1/32

(30) Priority: **07.08.92 US 926728**

(43) Date of publication of application:
**16.03.94 Bulletin 94/11**

(84) Designated Contracting States:
**DE FR GB**

(71) Applicant: **NATIONAL SEMICONDUCTOR CORPORATION**
**2900 Semiconductor Drive,**
**P.O. Box 58090**
**Santa Clara, California 95052-8090(US)**

(72) Inventor: **Wile, Donald T.**
**2771 Longford Drive**
**San Jose, California 95132(US)**

(74) Representative: **Horton, Andrew Robert Grant et al**
**BOWLES HORTON**
**Felden House**
**Dower Mews**
**High Street**
**Berkhamsted Hertfordshire HP4 2BL (GB)**

(54) **Cross coupled op-amp input transconductance reduction.**

(57) A monolithic silicon, planar epitaxial, PN junction isolated integrated circuit employing an input stage for an operational amplifier in which the input stage displays reduced transconductance. This provides a means for reducing the size of the amplifier compensation capacitor which typically requires the most chip area of any circuit component. The transconductance reduction is achieved by forming the input stage from ratioed plural collector lateral transistors (15,16) which drive a current mirror load (17). The plural collectors are cross-coupled to the current mirror load and the collector ratio determines the transconductance reduction.

Fig_5

This invention relates to operational amplifiers and the reduction of transconductance thereof.

In an operational amplifier (op-amp) the input stage is usually a differential amplifier (diff-amp). This input stage typically drives a transimpedance stage which provides the desired output and which typically includes a compensation capacitor that acts as a negative feedback element that converts the transimpedance stage into a Miller integrator. In order to reduce the off-chip components in an integrated circuit (IC), it has become common to include the compensation capacitor as an on-chip component. Unfortunately, this element usually requires the most chip area of any of the IC components.

As shown in US-A-3,801,923, the size of the compensation capacitor can be reduced by lowering the transconductance of the input stage. This patent covers an input stage composed of plural collector lateral PNP transistors. One collector of each of the input transistors is coupled to a conventional current mirror load. A second collector in each input transistor conducts a current that is passed to the negative supply terminal rather than the current mirror load. This results in a transconductance reduction that can be controlled by the relative sizes of the transistor collectors. Thus, the transconductance reduction can be controlled by geometric factors.

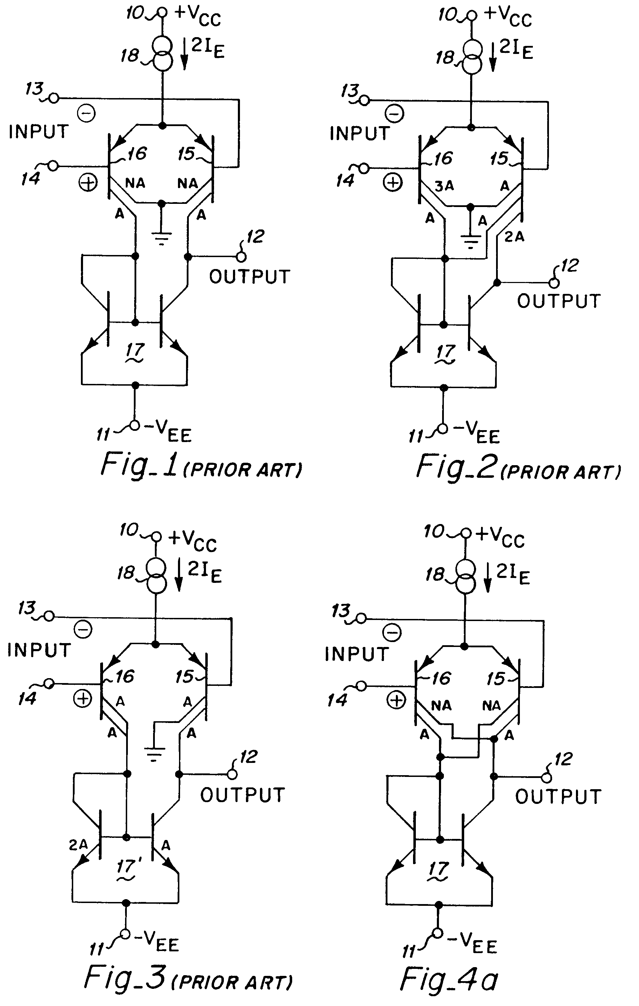

In the book titled "INTUITIVE IC OP AMPS", by Thomas M. Frederiksen (copyright 1984), the transconductance reduction is shown on page 38. The circuit (Figure 1-32) is said to maintain a high emitter current in the input transistors that minimizes phase lag and maintains the slew rate while reducing the size and area of the compensating capacitor. It is stated that this circuit, along with conventional layout optimizations, resulted in a four fold reduction in the chip size of a redesigned 740 operational amplifier.

In the classical paper titled "THE MONOLITHIC OP AMP: A TUTORIAL STUDY", by James E. Solomon and published in the IEEE Journal of Solid-State Circuits, Vol. 9, No. 6, December 1974, the Solomon et al. circuit is shown in figure 27. Figure 28 shows two alternative circuits useful in transconductance reduction. In Figure 28(a) two four-collector transistors are employed in the input stage. One collector from each of the differentially operated input transistor pair is connected to the current mirror load input and two of one of the transistor collectors are coupled to the load to produce the output. This configuration results in d-c balance and signal cancellation at the current mirror load input. This removes the pole normally associated with the load. Since three-fourths of the stage emitter current does not contribute to the output, the transconductance is reduced by a factor of four. This circuit has the disadvantage of degraded noise performance. In Figure 28(b) the dual collectors are employed in the input stage transistor pair. These collectors are sized equally and both collectors of one transistor are coupled to the current mirror input. One collector of the second transistor is coupled to the current mirror output. The current mirror is constructed to have a current gain of 0.5 to achieve d-c balance. This means that the current mirror input will receive an increased current which acts to suppress the pole. This circuit has the disadvantage of requiring ratioed devices in the current mirror load as well as the active PNP transistors.

Summary of the Invention

It is an object of the invention to provide a transconductance reduction in an op-amp input stage in which a large reduction can be achieved while maintaining pole suppression and reduced noise.

It is a further object of the invention to cross-couple the plural collectors in an op-amp input stage to the current mirror load wherein the collectors are ratioed to control the transconductance reduction while maintaining pole reduction and reduced noise.

In a preferred form of the invention the op-amp input stage employs at least a pair of plural collector transistors which are operated differentially. The plural collector lateral devices are cross-coupled to the current mirror load and are ratioed to determine the amount of transconductance reduction. If a unity ratio were to be employed complete signal cancellation would occur thereby resulting in an infinite reduction to zero transconductance. If the collector ratio is other than unity a geometry-controlled gain reduction is present. Thus, for large gain reductions where the ratioing is close to unity, the transistor noise is substantially cancelled. In any case, all the emitter current is passed by the current mirror thus minimizing the effect of the load pole.

Figure 1 is a schematic diagram of a reduced transconductance input stage widely used in the prior art.

Figure 2 is a schematic diagram of an alternative prior art reduced transconductance input stage.

Figure 3 is a schematic diagram of another alternative prior art reduced transconductance input stage.

Figure 4a is a schematic diagram of a reduced transconductance input stage employing the invention.

Figure 4b is a schematic of an alternative embodiment of the invention.

Figure 5 is a schematic diagram of an op-amp having an input stage employing reduced transconductance in accordance with the invention.

Figure 1 is a schematic diagram of the commonly used prior art reduced transconductance input stage. When one thinks of reducing the transconductance of a differential stage, the first approach would be to reduce the tail current. However, this is undesirable because the transistor's intrinsic emitter resistance would rise, thereby undesirably affecting the input stage's phase lag. The alternative approach, which would include the use of a pair of unbypassed emitter resistors, produces a similar result, thereby making this approach undesirable.

The circuit shown in Figure 1 is the one set forth in the above-identified Frederiksen publication as Figure 1-32. The circuit operates from power supplies $+ V_{CC}$ connected to terminal 10 and $- V_{EE}$ connected to terminal 11. The output at terminal 12 is the result of a differential input at terminals 13 and 14. Transistors 15 and 16 are plural collector lateral devices operated differentially by means of a tail current source 18 which is commonly coupled to both emitters. A current mirror load 17 provides a single-ended stage output at terminal 12. Thus, load 17 produces a differential-to-stage ended signal conversion. TransistorS 15 and 16 present matched collectors of area A to load 17 and each transistor includes a ratioed collector (of area NA) returned to ground. The current passed to ground does not contribute any output at terminal 12 so that the circuit transconductance is reduced. The reduction is directly proportional to N + 1, where N is the collector ratio. When N is unity, (equal area collectors) there is a small (two to one) reduction and when N is large, a large reduction is obtained.

Figure 2 is a schematic diagram of a circuit which is set forth in the above-referenced Solomon et al. paper to constitute a useful variation. Where the circuit elements are the same as those of Figure 1, the same numerals are employed. Transistors 15 and 16 are both preferably constructed as four collector lateral PNP devices in which the collectors each represent one of four quadrants arrayed about a single round emitter. In transistor 16, three of the four collectors are connected together to ground and one collector is connected to the input of current mirror load 17. One collector of transistor 15 is also connected to the input of current mirror load 17, thereby cross-coupling the collectors and providing two collectors at input of the current mirror. Two collectors of transistor 15 are connected to the output of current mirror load 17 thereby balancing the direct current conditions. However, because of the cross-coupling there is no signal appearing at the input of current mirror load 17. Thus, the circuit of Figure 2 has a four-fold reduction of transconductance. This is the same as Figure 1 when four collector transistors are employed and the transconductance reduction ratio (N + 1) is four to one. In the circuit of Figure 2, since there is no signal at the input of current mirror load 17, the load pole is eliminated. This circuit has the drawback that the uncorrelated noise currents coming from the two PNP's add rather than subtract at the input to the current mirror, thereby degrading the noise performance.

Figure 3 is another known circuit which employs dual collector transistors 15 and 16. In such devices, the lateral PNP transistors are constructed with equal value semi-circular elements around a single round emitter. If desired, four-collector transistors, as described above, could be used, with two quadrant elements in each connected together. In transistor 16 the collector pair is connected to the input of current mirror load 17' and one collector of transistor 15 is connected to the output of load 17'. The other collector in transistor 15 is grounded. The transistors of current mirror load 17' have a 2:1 ratio, thereby producing a current gain of 0.5. This is required for a direct current balance in the circuit. The advantage of the Figure 3 circuit is that all of the current in transistor 16 flows into the input of current mirror load 17'. Thus, the pole produced in the load is minimized. The transconductance reduction thus obtained is two to one. The main disadvantage is that the NPN transistors in load 17' must be ratioed to provide circuit balance.

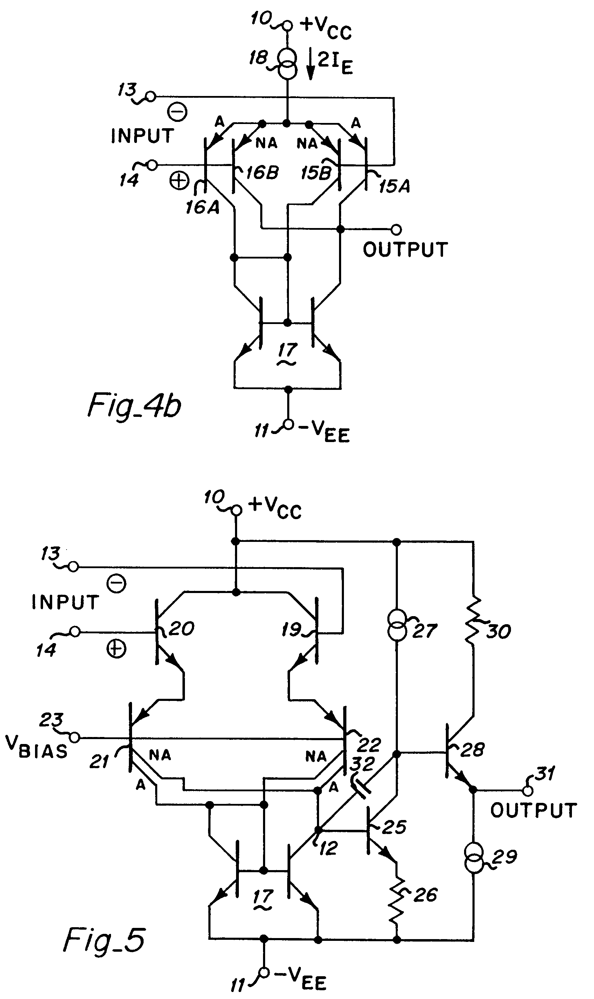

Figure 4 is a schematic diagram of one circuit according to the invention. Again, where the circuit elements function in the same manner as those of the previous figures, the same numerals are employed. For comparison, the plural collector lateral transistors are shown with an area ratio of N. Where four collector devices are employed, (N + 1) is 4. It can be seen that the NA collectors are cross-coupled with respect to the A collectors which are directly coupled to the current mirror load 17. Thus, if N is unity, the circuit is balanced and the transconductance is zero to produce a maximum reduction. If N is zero, there is no transconductance reduction, so the reduction is inversely proportional to N. Thus, the transconductance is directly proportional to 1-N, where N is between zero and unity. If N exceeds unity the signal transmitted by the stage is inverted and transconductance reduction related to the reciprocal of 1-N.

In the circuit of Figure 4a, it can be seen that for each of transistors 15 and 16, the collectors would develop correlated noise. Since the collectors are cross-coupled to the current mirror load noise cancellation would result. For example, if N is unity and the transconductance is close to zero, the noise produced by transistors 15 and 16 will cancel. Thus, it can be seen that, as the circuit is operated to reduce transconductance, it will also generate proportionately reduced noise.

While it is preferred that the collectors labelled A in transistors 15 and 16 should be matched and current mirror designed to have unity gain by employing matched transistors, this does not have to be the case. If desired, the mirror transistors can be ratioed. When this is done the current mirror must be ratioed to match the driving collectors. Thus, transistor 15 would include the A and NA collectors, while transistor 16 would have B and NB collectors. Current mirror 17 would then be ratioed to have a current gain of A/B.

While Figure 4a shows the use of plural-collector lateral transistors, a functional equivalent could be composed of four separate lateral transistors as shown in Figure 4b. The four transistors, 15A, 15B, 16A and 16B, are coupled together in differentially operated pairs and their collectors are cross-coupled to the current mirror load. The transistor emitter areas would be ratioed, as shown, to produce the desired transconductance reduction. However, in such a configuration, the individual transistors comprising each pair will generate uncorrelated noise thereby producing a somewhat inferior noise figure.

Figure 5 is a schematic diagram of an op-amp circuit that employs the transconductance reduction feature of the invention. Here an alternative means for differential operation of PNP transistors 21 and 22 is employed. Transistors 21 and 22 are plural collector lateral PNP structures. Since the bases of transistors 21 and 22 are commonly connected to a source of bias at terminal 23, they can share a single epitaxial tub in the conventional planar, monolithic, silicon epitaxial PN junction isolated form of IC construction. The emitters of the two plural-collector transistors 21 and 22 are differentially operated by NPN emitter follower transistors 19 and 20. One collector from each of transistors 21 and 22 is connected to the input and output of current mirror load 17. The other collectors of transistors 21 and 22 are cross-coupled to the same terminals of current mirror load 17. In terms of the convention of the Figure 4 circuit the collector ratio value is N. The input stage transconductance is:

$$g_m = 2I_s (1-N)/(1 + N)$$

$I_s$ is the signal-produced current; and
N is the collector ratio for split collector PNP's or the emitter area ratio for individual PNP's.

It can be seen that when N is unity, the transconductance is zero. When N is zero the transconductance is equal to $2I_s$ which is the unreduced input stage transconductance. When N exceeds unity, the transconductance $g_m$ goes negative, thereby denoting a signal inversion and the transconductance is reduced in inverse proportion to N. For very large values of N, the transconductance reduction is small and the stage merely operates in the inverted state.

Circuit node 12 comprises the output of the diff-amp input stage which operates to drive common emitter transistor amplifier 25. Resistor 26 acts to stabilize and degenerate the gain of transistor 25 while current source 27 forms the load element. The output of transistor 25 drives the input of emitter follower transistor 28 which includes load current sink 29 and collector resistor 30, and drives output terminal 31. In the op-amp of Figure 5, the base of transistor 19 comprises the inverting input and the base of transistor 20 the non-inverting input. Capacitor 32 comprises the frequency compensation element. Its value, and hence IC chip area, can be reduced in proportion to the transconductance reduction produced by the ratioed PNP transistors described above.

Example

The circuit of Figure 5 was constructed using a ratio of N = 1/3 for transistors 21 and 22. As a practical matter, the split-collector transistors 21 and 22 were each constructed as four collector devices with three of the four connected together to form the large collectors. Thus, the smaller collector was ratioed at 1/3 of the larger. Thus, (1-N)/(1/N) was 0.5. The following component values were employed:

| COMPONENT | VALUE |
|---|---|
| Resistor 26 | 100 ohms |
| Current Source 27 | 16 microamperes |
| Current Sink 29 | 161 microamperes |
| Resistor 30 | 500 ohms |

The circuit, when operated from a 5 volt power supply, produced an overall operating gain of about 75 db and drew a total current of about 0.3 ma. Frequency compensation capacitor 32 required a value of one pF. Without the two-to-one transconductance reduction afforded by the circuit input stage transistors 21 and 22, capacitor 32 would have to be twice as large.

**Claims**

1. A differential amplifier input stage for use in integrated circuit form, having a pair of input terminals responsive to a differential input signal, said stage having transconductance reduction means and comprising:
   a plurality of transistors, each having emitter, base and collector electrodes;
   means for operating a first pair of said plurality differentially;
   means for operating a second pair of said plurality differentially, said second pair being ratioed with respect to said first pair;
   current mirror load means coupled to receive the currents flowing in said first pair; and
   means for cross-coupling the collectors of said second pair to said current mirror load whereby the collector signal current contribution of said second pair opposes that of said first pair and the transconductance of said stage is reduced as a function of said ratio.

2. A differential amplifier input stage according to claim 1 wherein said IC form is of monolithic, planar, epitaxial silicon, PN junction isolation construction and said plurality of transistors comprise individual lateral transistors and the emitter areas are ratioed to achieve said ratio.

3. A differential amplifier input stage according to claim 1 wherein said form is of monolithic, planar, epitaxial silicon, PN junction isolation, construction and said plurality of transistors comprises a pair of lateral transistors employing ratioed plural collectors surrounding a single emitter and wherein the collector ratio magnitude determines the degree of said transconductance reduction.

4. A differential amplifier input stage according to claim 3 wherein a pair of said lateral transistors is employed and each one of said pair comprise four collector devices and said collector size ratio is equal to three.

5. A differential amplifier input stage according to claim 3 wherein said first pair of transistors have individual collectors that are ratioed with respect to each other and said current mirror has a current gain equal to the value of said individual collectors ratio.

6. A differential amplifier input stage according to claim 1 wherein said means for operating said first and second transistors differentially comprises:
   means coupling the emitter electrodes of said first and second transistors together; and
   a constant current source coupled to said emitter electrodes whereby the base electrodes of said first and second transistors comprise the differential amplifier input terminals.

7. A differential amplifier input stage according to claim 1 wherein said means for operating said first and second transistors differentially comprises:
   means for coupling the base electrodes of said first and second transistors in common to a source of bias potential; and
   means for driving the emitter electrodes differentially from the input terminals of said differential amplifier input stage.

Fig_1 (PRIOR ART)

Fig_2 (PRIOR ART)

Fig_3 (PRIOR ART)

Fig_4a

Fig_4b

Fig_5

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-4 223 276 (K. NAGANO) <br> * the whole document * <br> --- | 1-6 | H03F3/45 <br> H03F1/32 |
| X | US-A-3 979 689 (O.H. SCHADE) <br> * column 6, line 1 - column 7, line 54; figure 3 * <br> --- | 1-7 | |
| X | US-A-3 936 731 (C.F. WHEATLEY JR) <br> * column 8, line 33 - line 54; figure 12 * <br> ----- | 1-6 | |

**TECHNICAL FIELDS SEARCHED (Int.Cl.5)**

H03F

The present search report has been drawn up for all claims

| Place of search | Date of completion of the search | Examiner |
|---|---|---|
| THE HAGUE | 29 October 1993 | TYBERGHIEN, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)